# EUROPEAN PATENT APPLICATION

(11) **EP 4 383 291 A2**
(43) Date of publication of application: **12.06.2024**
(21) Application number: 23180285.1
(22) Date of filing: 20.06.2023
(51) Int. Cl.: H01G 2/14, H01G 2/06, H01G 4/232, H01G 4/30, H05K 1/02, H05K 1/11, H05K 1/18, H01G 4/228

(54) **ELECTRONIC COMPONENT AND BOARD HAVING ELECTRONIC COMPONENT MOUNTED THEREON**

(30) Priority: 08.12.2022 KR 20220170253
(71) Applicant: Samsung Electro-Mechanics Co., Ltd., Gyeonggi-do (KR)
(72) Inventor: Park, Heung Kil, Suwon-si, Gyeonggi-do (KR)
(74) Representative: Grünecker Patent- und Rechtsanwälte PartG mbB

(57) **Abstract**

An electronic component includes a multilayer electronic component including an ESD discharge member including a substrate and conductors, and external electrodes. The conductors include discharge electrode layers disposed on the substrate to be spaced apart from each other and connected to the external electrodes. The discharge electrode layers have a protrusion formed to extend, and the protrusion has a shape having a narrowing width.

## Description

### CROSS-REFERENCE TO RELATED APPLICATION(S)

This application claims benefit of priority to Korean Patent Application No. 10-2022-0170253 filed on December 8, 2022 in the Korean Intellectual Property Office, the disclosure of which is incorporated herein by reference in its entirety.

### TECHNICAL FIELD

The present disclosure relates to an electronic component and a board having the same mounted thereon.

### BACKGROUND

A multilayer ceramic capacitor (MLCC), a multilayer electronic component, is a chip-type condenser mounted on the printed circuit boards of various types of electronic products such as imaging devices, including a liquid crystal display (LCD) and a plasma display panel (PDP), computers, smartphones, and mobile phones, and serves to charge or discharge electricity therein or therefrom.

The multilayer ceramic capacitor may be used as a component of various electronic devices due to having a small size, ensuring high capacitance and being easily mounted. With the miniaturization and implementation of high output power in various electronic devices such as computers and mobile devices, demand for miniaturization and implementation of high capacitance of multilayer ceramic capacitors has also been increasing.

The spread of electronic devices in schemes such as the Internet of Things is expected to increase further in the future, starting with smartphones. Accordingly, it is becoming important to prepare for electrostatic discharge (ESD) due to contact with a human body or an electronic device. In order to prepare for ESD, a component such as an ESD suppressor may be used, thereby minimizing the effect of static electricity.

### SUMMARY

An aspect of the present disclosure is to effectively control ESD of a multilayer electronic component by disposing an ESD discharge member on a mounting surface of the multilayer electronic component.

Another aspect of the present disclosure is to improve space utilization of an electronic component mounted on a board by selectively disposing an ESD discharge member on one surface of a multilayer electronic component.

Another aspect of the present disclosure is to effectively control ESD depending on an applied voltage, a capacitance of a multilayer electronic component, or the like by allowing a plurality of ESD discharge members to be disposed together with one multilayer electronic component.

However, the aspects of the present disclosure are not limited to those set forth herein, and will be more easily understood in the process of describing specific example embodiments of the present disclosure.

According to an aspect of the present disclosure, an electronic component may include an ESD discharge member including a substrate having first and second surfaces opposing each other and first and second conductors disposed on the first and second surfaces of the substrate, and a multilayer electronic component disposed on the second surface of the substrate. The multilayer electronic component may include a body and first and second external electrodes disposed outside the body and respectively connected to the first and second conductors. The first and second conductors may include first and second discharge electrode layers disposed on the second surface of the substrate to be spaced apart from each other and respectively connected to the first and second external electrodes. The first discharge electrode layer may have a first protrusion extending in a direction toward the second discharge electrode layer, and the second discharge electrode layer may have a second protrusion extending in a direction toward the first discharge electrode layer. An end of the first protrusion may have a shape having a width narrowing in the direction toward the second discharge electrode layer, and an end of the second protrusion may have a shape having a width narrowing in the direction toward the first discharge electrode layer.

According to another aspect of the present disclosure, a board having an electronic component mounted thereon may include a printed circuit board including at least one pair of electrode pads thereon, an electronic component disposed on the printed circuit board, and a solder connecting the electrode pad and the electronic component to each other. The electronic component may include a multilayer electronic component including a body and first and second external electrodes disposed outside the body, and an ESD discharge member disposed between the multilayer electronic component and the printed circuit board. The ESD discharge member may include a substrate having first and second surfaces opposing each other and first and second conductors disposed on the first and second surfaces of the substrate. The first and second conductors may include first and second discharge electrode layers disposed on the second surface of the substrate to be spaced apart from each other and respectively connected to the first and second external electrodes. The first discharge electrode layer may have a first protrusion extending in a direction toward the second discharge electrode layer, and the second discharge electrode layer may have a second protrusion extending in a direction toward the first discharge electrode layer. An end of the first protrusion may have a shape having a width narrowing in the direction toward the second discharge electrode layer, and an end of the second protrusion may have a shape having a width narrowing in the direction toward the first discharge electrode layer.

According to still another aspect of the present disclosure, an electronic component may include an ESD discharge member including a substrate having first and second surfaces opposing each other and first and second conductors disposed on the first and second surfaces of the substrate; and a multilayer electronic component disposed on the second surface of the substrate. The multilayer electronic component may include a body and first and second external electrodes disposed outside the body and respectively connected to the first and second conductors. The first and second external electrodes may be spaced apart from each other in a length direction of the body. The first and second conductors may include first and second discharge electrode layers disposed on the second surface of the substrate to be spaced apart from each other in the length direction and respectively connected to the first and second external electrodes. A gap between the first and second discharge electrode layers in the length direction may be smaller at a center of the substrate than at a side edge of the substrate.

According to yet another aspect of the present disclosure, an electronic component may include an ESD discharge member including a substrate having first and second surfaces opposing each other and first and second conductors disposed on the first and second surfaces of the substrate; and a multilayer electronic component disposed on the second surface of the substrate. The multilayer electronic component may include a body and first and second external electrodes disposed outside the body and respectively connected to the first and second conductors. The first and second conductors may include first and second discharge electrode layers disposed on the second surface of the substrate, having a gap therebetween, and respectively connected to the first and second external electrodes. The first discharge electrode layer may have a first protrusion extending in a direction toward the second discharge electrode layer, and the second discharge electrode layer may have a second protrusion extending in a direction toward the first discharge electrode layer. An end of the first protrusion and an end of the second protrusion each may have a tapered shape.

According to example embodiments of the present disclosure, an ESD discharge member may be disposed on a mounting surface of a multilayer electronic component, thereby effectively controlling ESD of the multilayer electronic component.

According to example embodiments of the present disclosure, an ESD discharge member may be selectively disposed on one surface of a multilayer electronic component, thereby improving space utilization of an electronic component mounted on a board.

According to example embodiments of the present disclosure, a plurality of ESD discharge members may be allowed to be disposed together with one multilayer electronic component, thereby effectively controlling ESD depending on an applied voltage, a capacitance of a multilayer electronic component, or the like.

The various and beneficial advantages and effects of the present disclosure are not restricted to those set forth herein, and will be more easily understood in the process of describing specific example embodiments.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic perspective view of a multilayer electronic component according to an example embodiment of the present disclosure;
FIG. 2 is a schematic exploded perspective view of a structure in which the internal electrode of FIG. 1 is stacked;
FIG. 3 is a schematic cross-sectional view taken along line I-I' of FIG. 1;
FIG. 4 is a schematic perspective view of an electronic component according to an example embodiment of the present disclosure;
FIG. 5 is a schematic perspective view of the ESD discharge member of FIG. 4;
FIG. 6A is a schematic plan view of a second surface of the ESD discharge member of FIG. 5 in a first direction, and FIG. 6B is a schematic bottom view of a first surface of the ESD discharge member of FIG. 5 in a first direction;
FIGS. 7A, 7B, 7C and 7D are schematic plan views of second surfaces of various types of ESD discharge members in a first direction;
FIG. 8A is a schematic plan view of a second surface of an ESD discharge member having a plurality of protrusions and a plurality of through-holes in a first direction, and FIG. 8B is a schematic bottom view of a first surface of an ESD discharge member having a plurality of protrusions and a plurality of through-holes in a first direction;
FIG. 9 is a schematic cross-sectional view taken along line II'-II' of FIG. 4;
FIG. 10 is a schematic perspective view of an electronic component according to an example embodiment of the present disclosure;
FIG. 11 is a schematic perspective view of an electronic component according to an example embodiment of the present disclosure;
FIG. 12 is a schematic perspective view of a board having an electronic component mounted thereon according to an example embodiment in which the electronic component of FIG. 4 is disposed on a printed circuit board;
FIG. 13 is a schematic cross-sectional view taken along line III'-III' of FIG. 12; and
FIG. 14 is a schematic perspective view of a board having an electronic component mounted thereon, the electronic component obtained by additionally disposing an ESD discharge member on the electronic component of FIG. 12.

### DETAILED DESCRIPTION

Hereinafter, example embodiments of the present disclosure are described with reference to the accompanying drawings. The present disclosure may, however, be exemplified in many different forms and should not be construed as being limited to the specific example embodiments set forth herein. In addition, example embodiments of the present disclosure may be provided for a more complete description of the present disclosure to those skilled in the art. Accordingly, the shapes and sizes of the elements in the drawings may be exaggerated for clarity of description, and the elements denoted by the same reference numerals in the drawings may be the same elements.

In order to clearly illustrate the present disclosure, portions not related to the description are omitted, and sizes and thicknesses are magnified in order to clearly represent layers and regions, and similar portions having the same functions within the same scope are denoted by similar reference numerals throughout the specification. Throughout the specification, when an element is referred to as "comprising" or "including, " it means that it may include other elements as well, rather than excluding other elements, unless specifically stated otherwise.

In the drawings, a first direction may be defined as a thickness (T) direction, a second direction may be defined as a length (L) direction, and a third direction may be defined as a width (W) direction. In the present disclosure, the thickness (T) direction, the length (L) direction, and the width (W) direction do not refer to a thickness (T), a length (L), and a width (W). When an additional description is required in this regard, it will be described in detail.

### Multilayer Component

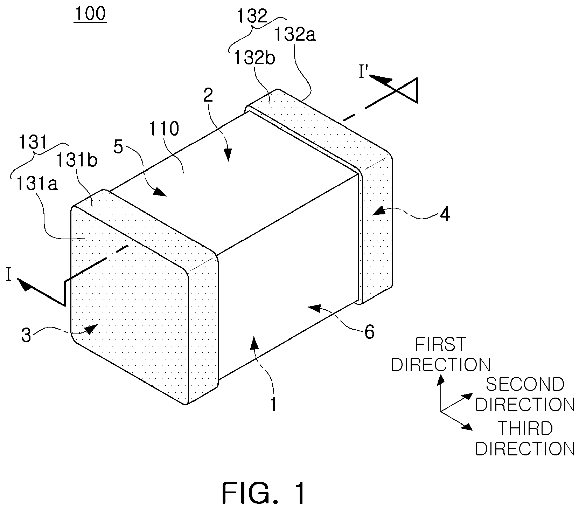

FIG. 1 is a schematic perspective view of a multilayer electronic component according to an example embodiment of the present disclosure.

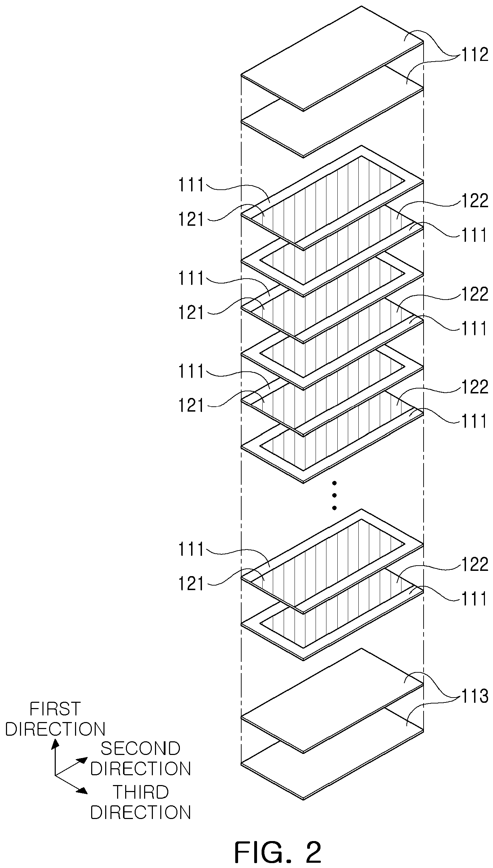

FIG. 2 is a schematic exploded perspective view of a structure in which the internal electrode of FIG. 1 is stacked.

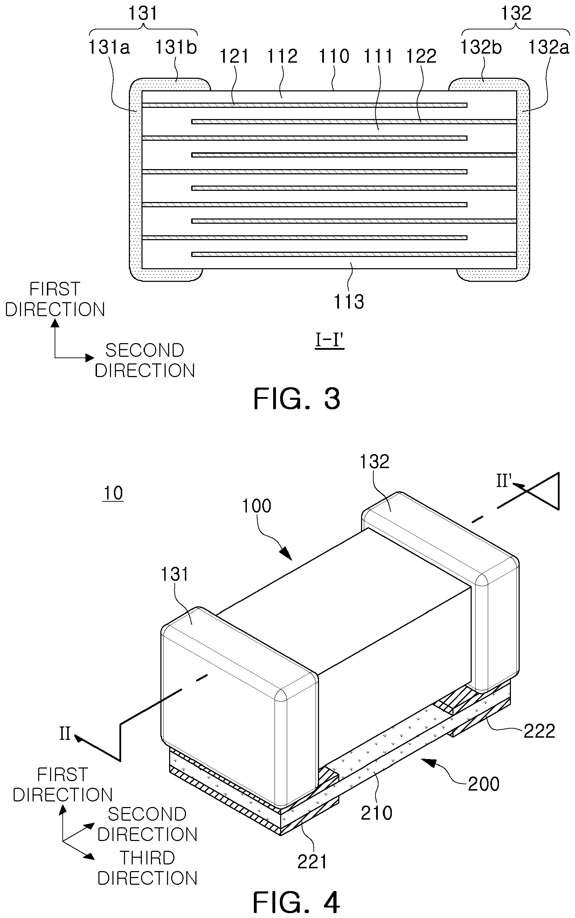

FIG. 3 is a schematic cross-sectional view taken along line I-I' of FIG. 1.

FIG. 4 is a schematic perspective view of an electronic component according to an example embodiment of the present disclosure.

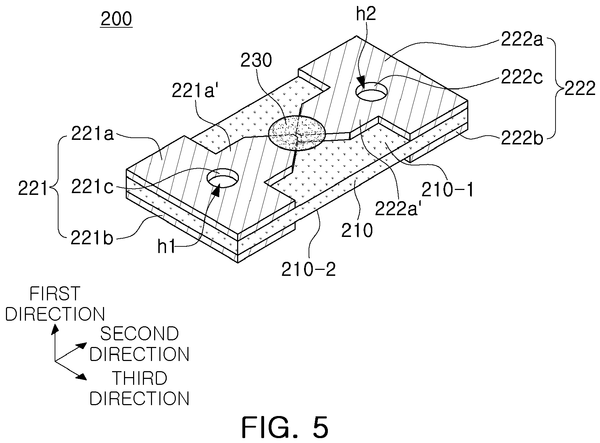

FIG. 5 is a schematic perspective view of the ESD discharge member of FIG. 4.

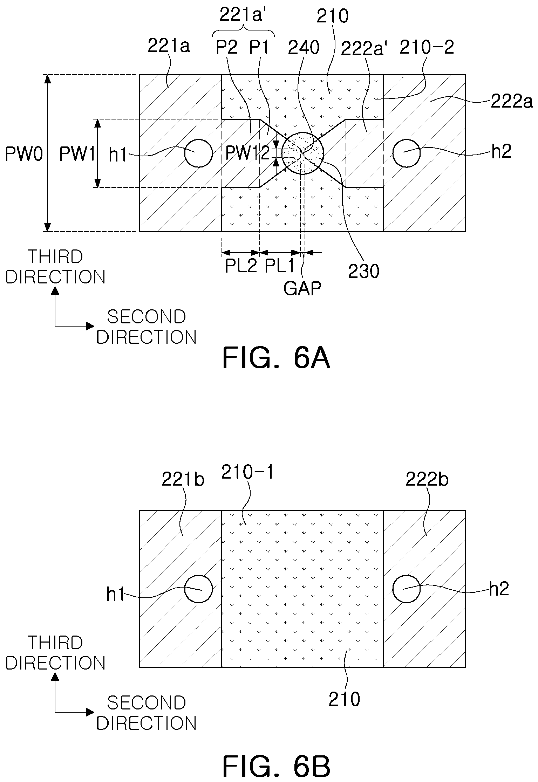

FIG. 6A is a schematic plan view of a second surface of the ESD discharge member of FIG. 5 in a first direction, and FIG. 6B is a schematic bottom view of a first surface of the ESD discharge member of FIG. 5 in a first direction.

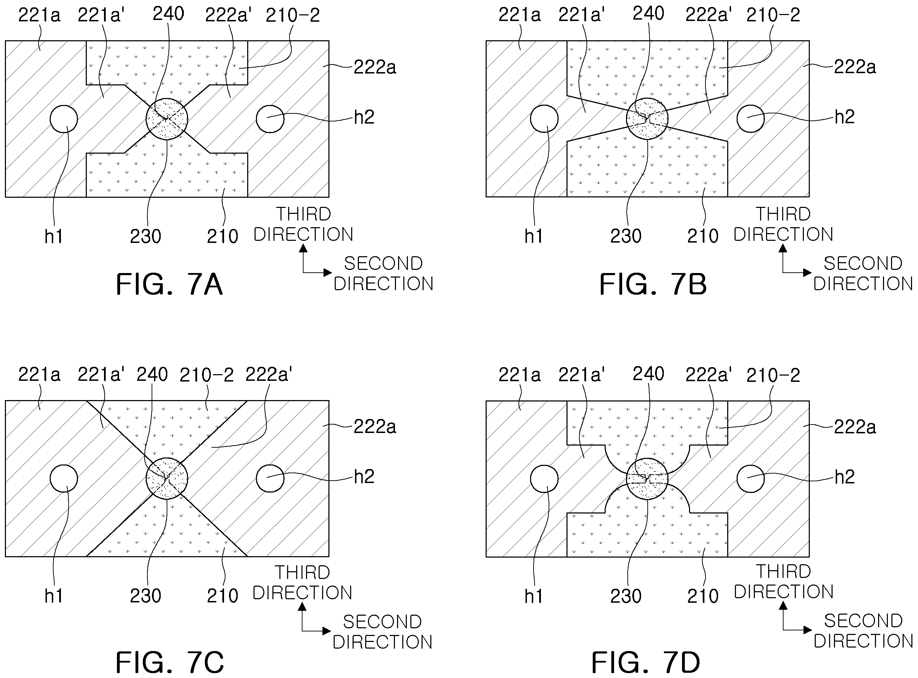

FIGS. 7A to 7D are schematic plan views of second surfaces of various types of ESD discharge members in a first direction.

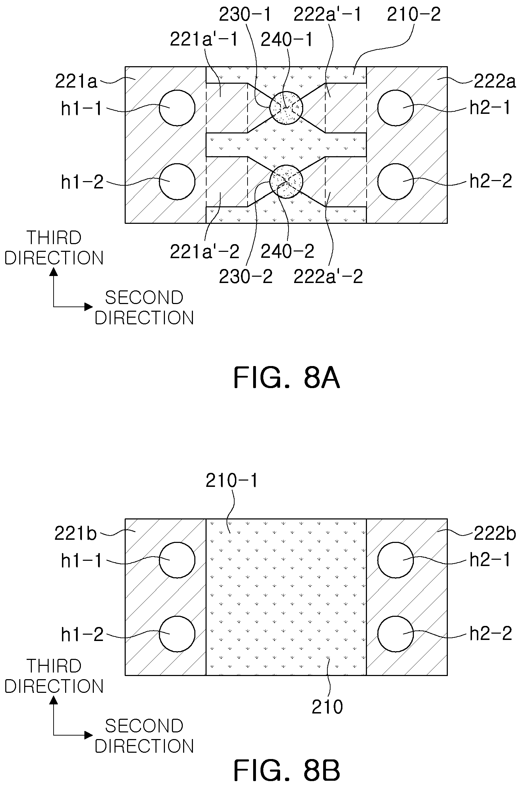

FIG. 8A is a schematic plan view of a second surface of an ESD discharge member having a plurality of protrusions and a plurality of through-holes in a first direction, and FIG. 8B is a schematic bottom view of a first surface of an ESD discharge member having a plurality of protrusions and a plurality of through-holes in a first direction.

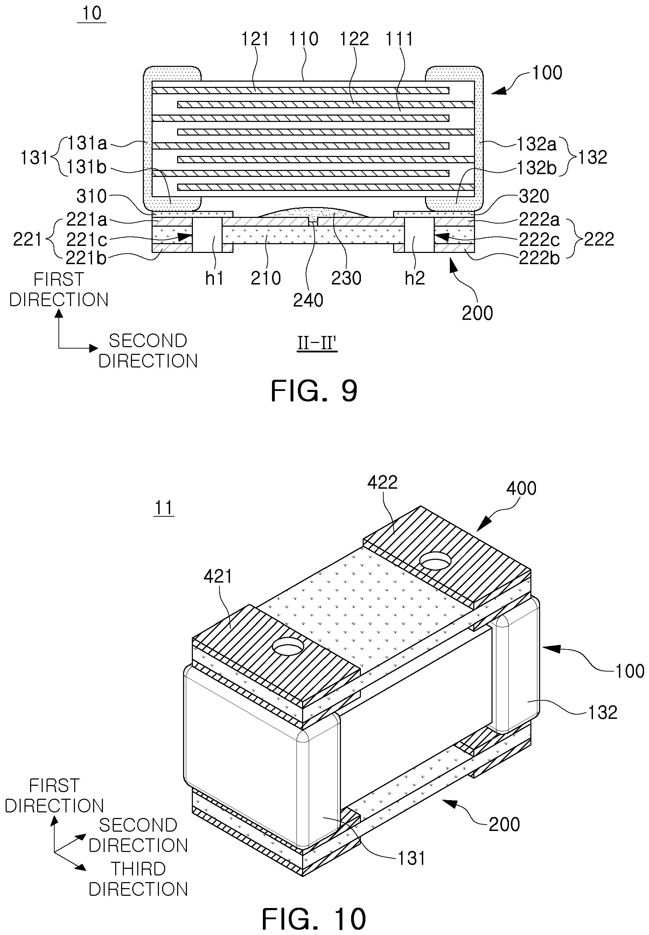

FIG. 9 is a schematic cross-sectional view taken along line II'-II' of FIG. 4.

FIG. 10 is a schematic perspective view of an electronic component according to an example embodiment of the present disclosure.

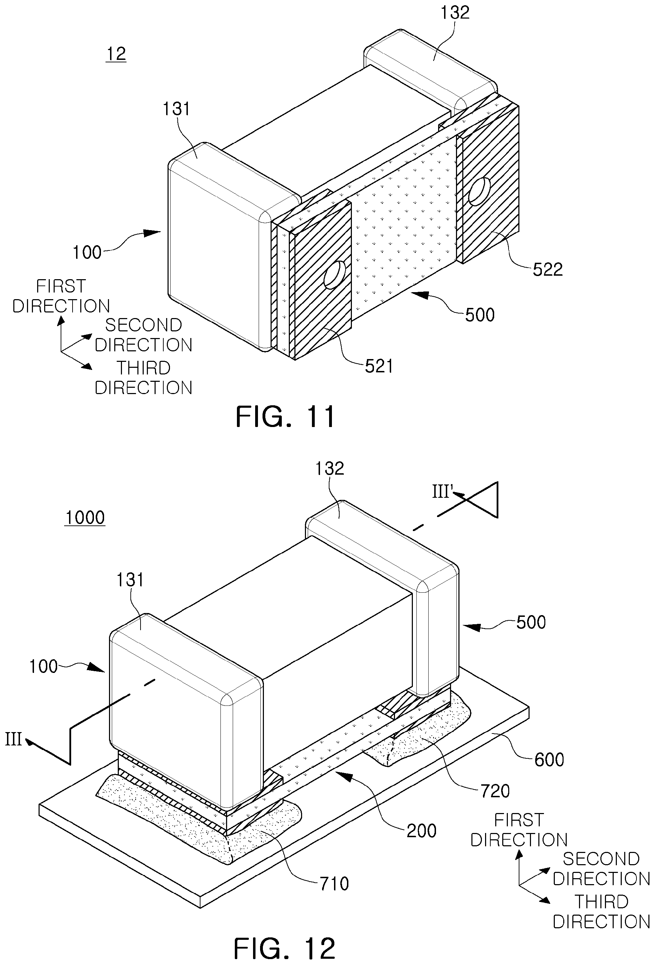

FIG. 11 is a schematic perspective view of an electronic component according to an example embodiment of the present disclosure.

Hereinafter, an electronic component according to an example embodiment of the present disclosure will be described in detail with reference to FIGS. 1 to 11. However, although a multilayer ceramic capacitor is described as an example of a multilayer electronic component among electronic components, the present disclosure may be applied to various electronic products using a dielectric composition, such as inductors, piezoelectric elements, varistors, thermistors, or the like.

According to an example embodiment of the present disclosure, an electronic component 10 may include an ESD discharge member 200 including a substrate 210 having first and second surfaces 210-1 and 210-2 opposing each other and first and second conductors 221 and 222 disposed on the first and second surfaces 210-1 and 210-2 of the substrate 210, and a multilayer electronic component 100 disposed on the second surface 210-2 of the substrate 210. The multilayer electronic component 100 may include a body 110 and first and second external electrodes 131 and 132 disposed outside the body 110 and respectively connected to the first and second conductors 221 and 222. The first and second conductors 221 and 222 may include first and second discharge electrode layers 221a and 222a disposed on the second surface 210-2 of the substrate 210 to be spaced apart from each other and respectively connected to the first and second external electrodes 131 and 132. The first discharge electrode layer 221amay have a first protrusion 221a' extending in a direction toward the second discharge electrode layer 222a, and the second discharge electrode layer 222a may have a second protrusion 222a' extending in a direction toward the first discharge electrode layer 221a. An end of the first protrusion 221a' may have a shape having a width narrowing in the direction toward the second discharge electrode layer 222a, and an end of the second protrusion 222a' may have a shape having a width narrowing in the direction toward the first discharge electrode layer 221a.

In the body 110, a dielectric layer 111 and internal electrodes 121 and 122 may be alternately stacked.

More specifically, the body 110 may include a capacitance formation portion Ac having capacitance formed by including the first internal electrode 121 and the second internal electrode 122 alternately disposed with the dielectric layer 111 interposed therebetween.

A specific shape of the body 110 is not particularly limited. However, as illustrated, the body 110 may have a hexahedral shape or a shape similar thereto. During a sintering process, ceramic powder particles included in the body 110 may be shrunken, such that the body 110 may not have a perfectly straight hexahedral shape, but may have a substantially hexahedral shape.

The body 110 may have first and second surfaces 1 and 2 opposing each other in a first direction, third and fourth surfaces 3 and 4 connected to the first and second surfaces 1 and 2 and opposing each other in a second direction, and fifth and sixth surfaces 5 and 6 connected to the first to fourth surfaces 1, 2, 3, and 4 and opposing each other in a third direction.

A plurality of dielectric layers 111 included in the body 110 may be in a sintered state, and adjacent dielectric layers 111 may be integrated with each other such that boundaries therebetween are not readily apparent without using a scanning electron microscope (SEM).

A raw material included in the dielectric layer 111 is not limited as long as sufficient capacitance is obtainable therewith. In general, a perovskite (ABO₃)-based material may be used. For example, a barium titanate-based material, a lead composite perovskite-based material, or a strontium titanate-based material may be used. The barium titanate-based material may include BaTiO₃-based ceramic powder. Examples of the ceramic powder may include (Ba₁₋ₓCaₓ) TiO₃ (0<x<1), Ba(Ti_{1-y}Ca_{y})O₃ (0<y<1), (Ba₁₋ₓCaₓ) (Ti_{1-y}Zr_{y})O₃ (0<x<1, 0<y<1), or Ba(Ti_{1-y}Zr_{y})O₃ (0<y<1) obtained by partially dissolving Ca or Zr in BaTiO₃.

In addition, as raw materials included in the dielectric layer 111, various ceramic additives, organic solvents, binders, and dispersants may be added to powder particles such as barium titanate (BaTiO₃), depending on the purpose of the present disclosure.

A thickness of each of the internal electrodes 121 and 122 is not particularly limited.

However, in order to more easily achieve miniaturization and implement high capacitance of the multilayer electronic component, the thickness of each of the internal electrodes 121 and 122 may be 0.6 um or less, and more preferably 0.4 um or less.

Here, a thickness of the dielectric layer 111 may refer to a thickness of the dielectric layer 111 interposed between the first and second internal electrodes 121 and 122.

The thickness of the dielectric layer 111 may refer to a size of the dielectric layer 111 in the first direction. In addition, the thickness of the dielectric layer 111 may refer to an average thickness of the dielectric layer 111, and may refer to an average size of the dielectric layer 111 in the first direction.

The average size of the dielectric layer 111 in the first direction may be measured by scanning, with an SEM, cross-sections of the body 110 in the first and second directions at a magnification of 10,000. More specifically, the average size may be an average value of sizes of one dielectric layer 111 in the first direction, measured at thirty points equally spaced apart from each other in the second direction, in the scanned image. In addition, when such average value measurement is performed on ten dielectric layers 111, the average size of the dielectric layer 111 in the first direction may be further generalized.

The internal electrodes 121 and 122 may be alternately stacked with the dielectric layer 111.

The internal electrodes 121 and 122 may include a first internal electrode 121 and a second internal electrode 122, and the first and second internal electrodes 121 and 122 may be alternately disposed to oppose each other with the dielectric layer 111 included in the body 110 interposed therebetween, and may be exposed through the third and fourth surfaces 3 and 4 of the body 110, respectively.

More specifically, the first internal electrode 121 may be spaced apart from the fourth surface 4, and may be exposed through the third surface 3, and the second internal electrode 122 may be spaced apart from the third surface 3, and may be exposed through the fourth surface 4. The first external electrode 131 may be disposed on the third surface 3 of the body 110 to be connected to the first internal electrode 121, and the second external electrode 132 may be disposed on the fourth surface 4 of the body 110 to be connected to the second internal electrode 122.

That is, the first internal electrode 121 may not be connected to the second external electrode 132 and may be connected to the first external electrode 131, and the second internal electrode 122 may not be connected to the first external electrode 131 and may be connected to the second external electrode 132. In this case, the first and second internal electrodes 121 and 122 may be electrically isolated from each other by the dielectric layer 111 interposed therebetween.

The body 110 may be formed by alternately stacking a ceramic green sheet on which the first internal electrode 121 is printed and a ceramic green sheet on which the second internal electrode 122 is printed, and then performing sintering thereon.

A material included in the internal electrodes 121 and 122 is not particularly limited, and a material having excellent electrical conductivity may be used. For example, the internal electrodes 121 and 122 may include at least one of nickel (Ni), copper (Cu), palladium (Pd), silver (Ag), gold (Au), platinum (Pt), tin (Sn), tungsten (W), titanium (Ti), and alloys thereof.

In addition, the internal electrodes 121 and 122 may be formed by printing an internal electrode conductive paste including at least one of nickel (Ni), copper (Cu), palladium (Pd), silver (Ag), gold (Au), platinum (Pt), tin (Sn), tungsten (W), titanium (Ti), and alloys thereof, on a ceramic green sheet. A screen-printing method or a gravure-printing method may be used as a method for printing the internal electrode conductive paste, but the present disclosure is not limited thereto.

The thickness of each of the internal electrodes 121 and 122 is not particularly limited.

However, in order to more easily achieve miniaturization and implement high capacitance of the multilayer electronic component, the thickness of each of the internal electrodes 121 and 122 may be 0.6 um or less, and more preferably 0.4 um or less.

Here, the thickness of each of the internal electrodes 121 and 122 may refer to a size of each of the internal electrodes 121 and 122 in the first direction. In addition, the thickness of each of the internal electrodes 121 and 122 may refer to an average thickness of each of the internal electrodes 121 and 122, and may refer to an average size of each of the internal electrodes 121 and 122 in the first direction.

The average size of each of the internal electrodes 121 and 122 in the first direction may be measured by scanning, with an SEM, an image of the cross-sections of the body 110 in the first and second directions at a magnification of 10,000. More specifically, the average size may be an average value of sizes of each of one internal electrode 121 or 122 in the first direction, measured at thirty points equally spaced apart from each other in the second direction, in the scanned image. The thirty points equally spaced apart from each other may be designated in the capacitance formation portion Ac. In addition, when an internal electrode on which such average value measurement is performed is extended to ten internal electrodes, the average size of each of the internal electrodes 121 and 122 in the first direction may be further generalized.

The body 110 may include cover portions 112 and 113 disposed on both end surfaces of the capacitance formation portion Ac in the first direction.

More specifically, the body 110 may include an upper cover portion 112 disposed on an upper portion of the capacitance formation portion Ac in the first direction, and a lower cover portion 113 disposed on a lower portion of the capacitance formation portion Ac in the first direction.

The upper cover portion 112 and the lower cover portion 113 may be formed by stacking a single dielectric layer 111 or two or more dielectric layers 111 in the first direction in upper and lower surfaces of the capacitance formation portion Ac, respectively, and may basically serve to prevent damage to the internal electrodes 121 and 122 caused by physical or chemical stress.

The upper cover portion 112 and the lower cover portion 113 may not include the internal electrodes 121 and 122, and may include a material the same as that of the dielectric layer 111. That is, the upper cover portion 112 and the lower cover portion 113 may include a ceramic material, for example, a barium titanate (BaTiO₃)-based ceramic material.

A thickness of each of the cover portions 112 and 113 is not particularly limited.

However, in order to more easily achieve miniaturization and implement of high capacitance of the multilayer electronic component, the thickness of each of the cover portions 112 and 113 may be 100 um or less, preferably 30 um or less, and more preferably 20 um or less in ultra-small products.

Here, the thickness of each of the cover portions 112 and 113 may refer to a size of each of the cover portions 112 and 113 in the first direction. In addition, the thickness of each of the cover portions 112 and 113 may refer to an average thickness of each of the cover portions 112 and 113, and may refer to an average size of each of the cover portions 112 and 113 in the first direction.

The average size of each of the cover portions 112 and 113 in the first direction may be measured by scanning, with an SEM, an image of the cross-sections of the body 110 in the first and second directions at a magnification of 10,000. More specifically, the average size may be an average value of thicknesses of one cover portion, measured at thirty points equally spaced apart from each other in the second direction, in the scanned image. The thirty points equally spaced apart from each other may be designated in the upper cover portion 112.

Although not illustrated in the drawings, a side margin portion may be disposed on both end surfaces of the body 110 in the third direction.

More specifically, the side margin portions may include a first side margin portion disposed on the fifth surface 5 of the body 110 and a second side margin portion disposed on the sixth surface 6 of the body 110. That is, the side margin portion may be disposed on the both end surfaces of the body 110 in the third direction.

The side margin portion may refer to a region between both ends of the first and second internal electrodes 121 and 122 in the third direction and a boundary surface of the body 110, based on the cross-sections of the body 110 in the second and third direction.

The side margin portion may basically serve to prevent damage to an internal electrode caused by physical or chemical stress.

The side margin portion may form the internal electrodes 121 and 122 by applying a conductive paste onto a ceramic green sheet, except a portion in which the side margin portion is to be formed. In order to suppress a step caused by the internal electrodes 121 and 122, the internal electrodes 121 and 122 may be stacked and cut to be exposed through the fifth and sixth surfaces 5 and 6 of the body 110, and then a single dielectric layer 111 or two or more dielectric layers 111 may be stacked on both end surfaces of the capacitance formation portion Ac in the third direction to form the margin portions 114 and 115.

A width of each of the first and second side margin portions is not particularly limited.

However, in order to more easily achieve miniaturization and implement high capacitance of the multilayer electronic component 100, the width of each of the first and second side margin portions may be 100 um or less, preferably 30 um or less, and more preferably 20 um or less in ultra-small products.

Here, a width of the side margin portion may refer to a size of the side margin portion in the third direction. In addition, the width of the side margin portion may refer to an average width of the side margin portion, and may refer to an average size of the side margin portion in the third direction.

The average size of the side margin portion in the third direction may be measured by scanning, with an SEM, an image of cross-sections of the body 110 in the first and third directions at a magnification of 10,000. More specifically, the average size may be an average value of sizes of one side margin portion in the third direction, measured at thirty points equally spaced apart from each other in the first direction, in the scanned image. The thirty points equally spaced apart from each other may be designated in the first side margin portion.

In an example embodiment of the present disclosure, a structure in which a ceramic electronic component 100 has two external electrodes 131 and 132 is described, but the number or shape of the external electrodes 131 and 132 may vary depending on the shape or other purposes of the internal electrodes 121 and 122.

The external electrodes 131 and 132 may be disposed outside the body 110, and may include first and second external electrodes 131 and 132 respectively connected to first and second conductors 221 and 222 to be described below.

The external electrodes 131 and 132 may be disposed on the body 110 to be connected to the internal electrodes 121 and 122.

More specifically, the external electrodes 131 and 132 may include the first and second external electrodes 131 and 132 disposed on the third and fourth surfaces 3 and 4 of the body 110 and connected to the first and second internal electrodes 121 and 122, respectively. That is, the first external electrode 131 may be disposed on the third surface 3 of the body 110 to be connected to the first internal electrode 121, and the second external electrode 132 may be disposed on the fourth surface 4 of the body 110 to be connected to the second internal electrode 122.

The first and second external electrodes 131 and 132 may include first and second connection portions 131a and 132a respectively disposed on the third and fourth surfaces 3 and 4 of the body 110, and first and second band portions 131b and 132b extending from the first and second connection portions 131a and 132a to portions of the first, second, fifth and sixth surfaces 1, 2, 5 and 6 of the body 110.

More specifically, the first external electrode 131 may include the first connection portion 131a and the first band portion 131b. The first connection portion 131a may be disposed on the third surface 3 of the body 110 to be electrically connected to the first internal electrode 121 exposed through the third surface 3 of the body 110. The first band portion 131b may be a portion extending from the first connection portion 131a to the portions of the first, second, fifth and sixth surfaces 1, 2, 5 and 6 of the body 110 for improvement in adhesive strength or contact with a first conductor 221.

The second external electrode 132 may include the second connection portion 132a and the second band portion 132b. The second connection portion 132a may be disposed on the fourth surface 4 of the body 110 to be electrically connected to the second internal electrode 122 exposed through the fourth surface 4 of the body 110. The second band portion 132b may be a portion extending from the second connection portion 132a to the first, second, fifth, and sixth surfaces 1, 2, 5, and 6 of the body 110 for improvement in adhesive strength or contact with a second conductor 222.

The external electrodes 131 and 132 may be formed using any material as long as it has electrical conductivity, such as metal, and a specific material may be determined in consideration of electrical properties, structural stability, and the like. Furthermore, the external electrodes 131 and 132 may have a multilayer structure.

For example, the external electrodes 131 and 132 may include an electrode layer disposed on the body 110 and a plating layer disposed on the electrode layer.

As a more specific example of the electrode layer, the electrode layer may be a sintered electrode including a conductive metal and glass, or a resin-based electrode including a conductive metal and resin.

In addition, the electrode layer may have a form in which the sintered electrode and the resin-based electrode are sequentially formed on the body 110.

In addition, the electrode layer may be formed by transferring a sheet including a conductive metal onto the body 110 or by transferring a sheet including a conductive metal onto the sintered electrode.

The conductive metal used in the electrode layer is not particularly limited as long as it may be electrically connected to the internal electrodes 121 and 122 to form capacitance. For example, the conductive metal may include at least one selected from the group consisting of nickel (Ni), copper (Cu), palladium (Pd), silver (Ag), gold (Au), platinum (Pt), tin (Sn), tungsten (W), titanium (Ti), and alloys thereof. The electrode layer may be formed by applying a conductive paste prepared by adding a glass frit to the conductive metal powder and then sintering the conductive paste.

The plating layer may serve to improve mounting properties.

A type of the plating layer is not particularly limited, and may be a single plating layer including at least one of nickel (Ni), tin (Sn), palladium (Pd), and alloys thereof, and may be formed as a plurality of plating layers.

For a more specific example of the plating layer, the plating layer may be a Ni plating layer or a Sn plating layer, may have a form in which a Ni plating layer and a Sn plating layer are sequentially formed on the electrode layer, and may have a form in which a Sn plating layer, a Ni plating layer, and a Sn plating layer are sequentially formed. In addition, the plating layer may include a plurality of Ni plating layers and/or a plurality of Sn plating layers.

An electronic component 10 according to an example embodiment of the present disclosure may include a multilayer electronic component 100 and an ESD discharge member 200.

The ESD discharge member 200 may include a substrate 210 having first and second surfaces 210-1 and 210-2 opposing each other, and first and second conductors 221 and 222 disposed on the first and second surfaces 210-1 and 210-2 of the substrate 210.

In the present disclosure, the first and second surfaces 1 and 2 of the body 110 may be different from the first and second surfaces 210-1 and 210-2 of the substrate 210, and respective configurations will be described separately from each other.

The ESD discharge member 200 may be disposed on one surface of the multilayer electronic component 100. For example, the ESD discharge member 200 may be disposed on one surface among the first, second, fifth and sixth surfaces 1, 2, 5, and 6. That is, the ESD discharge member 200 may be disposed on one surface in contact with the first and second band portions 131b and 132b.

Here, the ESD discharge member 200 may have a length and width less than those of the multilayer electronic component 100. More specifically, the ESD discharge member 200 may be formed inside an outermost point of the electronic component 200 at which the first and second external electrodes 131 and 132 are formed to thereby overlap portions of the first and second band portions 131b and 132b.

The ESD discharge member 200 may include a substrate 210 having first and second surfaces 210-1 and 210-2 opposing each other, first and second through-holes h1 and h2 passing through the substrate 210, and first and second conductors 221 and 222.

In this case, the multilayer electronic component 100 may be disposed on the second surface 210-2 of the substrate 210, and the first and second external electrodes 131 and 132 may be connected to the first and second conductors 221 and 222, respectively.

In an example embodiment of the present disclosure, at least one of the first through-hole h1 and the second through-hole h2 may be provided.

More specifically, the first through-hole h1 may include a first-first through-hole h1-1 and a first-second through-hole h1-2, and the first-first through-hole h1-1 and the first-second through-hole h1-2 may be spaced apart from each other. The second through-portion h2 may include a second-first through-portion h2-1 and a second-second through-portion h2-2, and the second-first through-portion h2-1 and the second-second through-portion h2-2 may be spaced apart from each other.

The substrate 210 may be formed of a high rigid material, for example, alumina, but the present disclosure is not particularly limited thereto.

One surface of the multilayer electronic component 100 may be disposed to be in contact with the second surface 210-2 of the substrate. The first surface 210-1 of the substrate may be a mounting surface on which the electronic component 10 is in contact with a printed circuit board 600.

The first and second conductors 221 and 222 may be spaced apart from each other to be symmetrical to each other in the second direction, and may be connected to the first and second external electrodes 131 and 132, respectively. In addition, when the electronic component 10 is mounted on the printed circuit board 600, the first and second conductors 221 and 222 may be connected to electrode pads 610 and 620 of the printed circuit board 600, respectively, thereby performing a function of connecting, to each other, the multilayer electronic component 100 and the printed circuit board 600.

The first and second conductors 221 and 222 may be formed by printing a conductive paste on the substrate 210. Here, the conductive paste may include at least one of nickel (Ni), copper (Cu), tin (Sn), or alloys thereof. However, the present disclosure is not limited thereto, and the first and second conductors 221 and 222 may be formed by dipping or using other methods such as plating, deposition, and the like.

The first and second conductors 221 and 222 may be formed to have a constant thickness on at least one surface among the first and second surfaces 210-1 and 210-2 of the substrate. The first and second conductors 221 and 222 may be formed flat to have a thickness equal to as that of the surface, as necessary.

Here, the thickness of each of the first and second conductors 221 and 222 may refer to a size in the first direction.

When the first and second conductors 221 and 222 are formed to have a thickness equal to those of the first and second surfaces 210-1 and 210-2 of the substrate, the substrate 210 may have a predetermined step with respect to a region in which the first and second conductors 221 and 222 are to be formed.

Here, a thickness of the substrate 210 may refer to a thickness of the substrate 210 when the substrate 210 is disposed on a mounting surface of the multilayer electronic component 100, in other words, a size of the substrate 210 in the first direction when the substrate 210 is disposed between the multilayer electronic component 100 and the printed circuit board 600, but the present disclosure is not particularly limited thereto. The thickness of the substrate 210 may refer to a size of a space between the first and second surfaces 210-1 and 210-2 of the substrate 210 when the first and second surfaces 210-1 and 210-2 of the substrate 210 are disposed to be parallel to one surface of the body 110.

The first and second conductors 221 and 222 may be disposed on the second surface 210-2 of the substrate 210 to be spaced apart from each other in the second direction to include first and second discharge electrode layers 221a and 222a respectively connected to the first and second external electrodes 131 and 132, and to include first and second lower-surface electrode layers 221b and 222b disposed on the first surface 210-1 of the substrate 210 to be spaced apart from each other in the second direction. In one embodiment, a gap between the first and second lower-surface electrode layers 221b and 222b in the second direction may be constant along the third direction.

In addition, first and second through-holes h1 and h2 may be formed in the substrate 210 to be symmetrical to each other in the second direction, and the first and second conductors 221 and 222 may include first and second via electrodes 221c and 222c, respectively covering internal surfaces of the first and second through-holes h1 and h2.

More specifically, the first conductor 221 may be disposed to be close to the third surface 3 of the body 110, and may include the first discharge electrode layer 221a, the first lower-surface electrode layer 221b, and the first via electrode 221c.

The first through-hole h1 may be formed to pass through the first discharge electrode layer 221a, the substrate 210, and the first lower-surface electrode layer 221b.

The first via electrode 221c, covering an internal surface of the first through-hole h1, may connect the first discharge electrode layer 221a and the first lower-surface electrode layer 221b to each other.

In other words, the first conductor 221, an integral body including the first via electrode 221c, may include the first lower-surface electrode layer 221b, covering at least a portion of the first surface 210-1 of the substrate 210, and the first discharge electrode layer 221a, covering at least a portion of the second surface 210-2 of the substrate 210.

The second conductor 222 may be disposed to be close to the fourth surface 4 of the body 110, and may include the second discharge electrode layer 222a, the first lower-surface electrode layer 222b, and the first via electrode 222c.

The second through-hole h2 may be formed to pass through the second discharge electrode layer 222a, the substrate 210, and the second lower-surface electrode layer 222b.

The second via electrode 222c, covering an internal surface of the second through-hole h2, may connect the second discharge electrode layer 222a and the second lower-surface electrode layer 222b to each other.

In other words, the second conductor 222, an integral body including the second via electrode 222c, may include the second lower-surface electrode layer 222b, covering at least a portion of the first surface 210-1 of the substrate 210, and the second discharge electrode layer 222a, covering at least a portion of the second surface 210-2 of the substrate 210.

The first and second conductors 221 and 222 may be respectively formed on the first surface 210-1 and the second surface 210-2 of the substrate 210 to be asymmetrical to each other. That is, the first and second lower-surface electrode layers 221b and 222b disposed on the first surface 210-1 of the substrate 210 may be different from the first and second discharge electrode layers 221a and 222a disposed on the second surface 210-2 of the substrate 210.

The first discharge electrode layer 221a may include a first protrusion 221a' extending in a direction toward the second discharge electrode layer 222a, and the second discharge electrode layer 222a may include a second protrusion 222a' extending in a direction toward the first discharge electrode layer 221a'.

In this case, an end of the first protrusion 221a' may have a shape having a width narrowing in the direction toward the second discharge electrode layer 222a, and an end of the second protrusion 222a' may have a shape having a width narrowing in the direction toward the first discharge electrode layer 221a.

In one embodiment, a gap between the first and second discharge electrode layers 221a and 222a in the second direction may be smaller at a center of the substrate 210 than at a side edge of the substrate 210.

In this embodiment, each of the first and second discharge electrode layers 221a and 222a may be divided into an outer region adjacent to the side edge of the substrate and an inner region adjacent to the center of the substrate.

In various embodiments, the gap between the outer regions of the first and second discharge electrode layers 221a and 222a in the second direction may be constant along the third direction, and the gap between the inner regions of the first and second discharge electrode layers 221a and 222a in the second direction may decrease as the gap approaches the center of the substrate 210 (e.g., FIGS. 7A, 7B, 7D, etc.).

In one embodiment, the gap between the inner regions of the first and second discharge electrode layers 221a and 222a in the second direction may decrease in a linear manner (e.g., FIGS. 6A, 7A, 7B, etc.).

On the other hand, in another embodiment, the gap between the inner regions of the first and second discharge electrode layers 221a and 222a in the second direction may decrease in a nonlinear manner (e.g., FIG. 7D).

In one embodiment, a step may be formed between the outer region and the inner region such that a maximum gap between the inner regions of the first and second discharge electrode layers 221a and 222a is smaller than the gap between the outer regions of the first and second discharge electrode layers 221a and 222a (e.g., FIGS. 7A and 7D).

In one embodiment, a maximum gap between the inner regions of the first and second discharge electrode layers 221a and 222a may be equal to the gap between the outer regions of the first and second discharge electrode layers 221a and 222a (e.g., FIG. 7B).

In one embodiment, an end of the inner region of each of the first and second discharge electrode layers 221a and 222a may have a shape having a sharp point (e.g., FIG. 7A) .

On the other hand, in another embodiment, an end of the inner region of each of the first and second discharge electrode layers 221a and 222a may have a flat surface (e.g., FISS. 6A, 7B, 7D, etc.).

In still another embodiment, both gaps in the outer and inner regions of the first and second discharge electrode layers 221a and 222a may continuously decrease in a linear manner (e.g., FIG. 7C).

In addition, in an example embodiment of the present disclosure, the first protrusion 221a' may include one or more first protrusions and the second protrusion may include one or more second protrusions (FIG. 8A).

More specifically, the first protrusion 221a' may include a first-first protrusion 221a'-1 and a first-second protrusion 221a'-2, and the second protrusion 222a' may include a second-first protrusion 222a'-1 and a second-second protrusion 222a'-2.

In this case, the first-first protrusion 221a'-1 and the second-first protrusion 222a'-1 may protrude toward each other to be spaced apart from each other with a predetermined first spacer portion 240-1. The first-second protrusion 221a'-2 and the second-second protrusion 222a'-2 may protrude toward each other to be spaced apart from each other with a predetermined second spacer portion 240-2.

Here, the first spacer 240-1 and the second spacer 240-2 may have different sizes.

More specifically, the first and second discharge electrode layers 221a and 222a may include first and second protrusions 221a' and 222a' formed to respectively extend from both ends thereof spaced apart from each other toward a central portion thereof, and a spacer portion 240 formed between the first and second protrusions 221a' and 222a'. The first and second protrusions 221a' and 222a' may have a first region P1 having a width decreasing toward each other.

That is, as illustrated, the first and second discharge electrode layers 221a and 222a may have a "T" shape, and narrow portions formed in the third direction may be formed to oppose each other.

In other words, the first and second conductors 221 and 222 may be formed to respectively extend from both ends opposing each other of the second surface 210-2 of the substrate 210 toward a central portion of the second surface 210-2 of the substrate 210. Portions of the first and second discharge electrode layers 221a and 222a disposed to oppose each other toward the central portion of the second surface 210-2 of the substrate 210 may be defined as the first and second protrusions 221a' and 222a'.

Accordingly, when the first and second discharge electrode layers 221a and 222a having a "T" shape are used, the first and second protrusions 221a' and 222a' may be formed to have a width narrower than that of the substrate 210.

In this case, the end of the first protrusion 221a' may have a shape having a width narrowing in the direction toward the second discharge electrode layer 222a, and the end of the second protrusion 222a' may have a shape having a width narrowing in the direction toward the first discharge electrode layer 221a.

In other words, the first and second protrusions 221a' and 222a' may have the first region P1, a region having a width decreasing toward each other.

Here, a direction of the width may be a direction, perpendicular to the first and second protrusions 221a' and 222a', more specifically, the third direction, but the present disclosure is not particularly limited thereto. For example, the width direction when the ESD emitting member is disposed on the fifth or sixth surface 5 or 6 of the multilayer electronic component may refer to the first direction.

That is, a width of each of the first and second protrusions 221a' and 222a' may refer to a size in the third direction.

In an example embodiment of the present disclosure, the end of the first protrusion 221a' and the end of the second protrusion 222a' may have a tapered shape.

That is, the first region P1 may have a tapered shape.

Here, the tapered shape may mean that inclinations of both side surfaces thereof are symmetrical to each other with respect to a central line thereof. When a central line passing through a central point of the first and second protrusions 221a' and 222a' is drawn in the second direction, the tapered shape may mean that inclinations of both side surfaces are formed to be symmetrical to each other in the third direction with respect to the central line in the second direction.

In this case, when a maximum width of each of the first and second discharge electrode layers 221a and 222a is defined as PW0, a width of one end among the ends of the first and second protrusions is defined as PW12, and a width of the other end among the ends of the first and second protrusions is defined as PW1, 0 ≤ PW1 < PW12 ≤ PW0 may be satisfied.

That is, a width of one end of the first region P1 may be defined as PW12, and a width of the other end of the first region P1 may be defined as PW1.

In the present disclosure, for ease of description, one end and the other end of the first protrusion 221a' may be described as being the same as one end and the other end of the second protrusion 222a', but the present disclosure is not particularly limited thereto.

That is, a width of one end of the first protrusion 221a' and a width of one end of the second discharge electrode layer 222a' may be defined as PW12. However, it does not mean that the one end of the first protrusion 221a' and the one end of the second discharge electrode layer 222a' have the same width. A width of each of the first protrusion 221a' and the second discharge electrode layers 222a' may be defined as PW12, and descriptions below may also have the same meaning.

One ends of the first regions P1 of the first and second protrusions 221a' and 222a' may refer to one ends at a short distance from first and second discharge electrode portions 221a and 222b, respectively. The other ends of the first regions P1 of the first and second protrusions 221a' and 222a' may refer to the other ends at a short distance from the first and second protrusions 221a' and 222a'.

In other words, one end of the first region P1 of the first protrusion 221a' may refer to one end at a short distance from the first discharge electrode layer 221, and the other end of the first region P1 of the first protrusion 221a' may refer to the other end at a short distance from the other end of the second protrusion 222a'. In addition, one end of the first region P1 of the second protrusion 222a' may refer to one end at a short distance from the second discharge electrode layer 222, and the other end of the first region P1 of the second protrusion 222a' may refer to the other end at a short distance from the other end of the first protrusion 221a'.

Among the ends of the first and second protrusions 221a' and 222a', the one end and the other end may be parallel to each other. That is, one end and the other end of the first region P1 may be parallel to each other.

In this case, a width PW2 of one end and a width PW1 of the other end of the first region P1 may be greater than 0 um, and may have a straight linear shape. In addition, the two straight lines may be parallel to each other. Here, "being parallel to each other" may mean "being substantially parallel to each other," not "being infinitely parallel to each other, " when two straight lines are extended.

The width PW1 of the other end of the first region P1 may satisfy 0 ≤ PW1.

In this case, the width PW1 having a value of "0" may refer to a vertex, and may refer to a vertex or a sharp point (FIG. 7A).

More specifically, the sharp point may include a vertex forming an angle at a point at which two straight lines meet, and may include a cusp point (sharp point) at which no angular measurement is possible at a point at which two curved lines meet.

That is, a decrease in width in the first region P1 may include a linear decrease in width (FIG. 7A), and may include a width decreasing in a curved shape (FIG. 7D), but the present disclosure is not particularly limited thereto, and may refer to anything having a sharp shape.

As the first and second protrusions 221a' and 222a' of the first and second discharge electrode layers 221a and 222a are sharper, an electric field E applied to the multilayer electronic component 100 may be easily gathered into the second protrusions 221a' and 222a', such that electric field concentration (electric intensity) may easily occur, and the concentrated electric field E may be discharged through an ESD discharge portion 240, thereby preventing the multilayer electronic component 100 from being damaged or defects from being occurring in the multilayer electronic component 100, due to the application of high voltage.

The width PW12 of the other end of the first region P1 may satisfy PW12 ≤ PW0.

More specifically, the width PW12 of the other end of the first region P1 being equal to the maximum width PW0 of each of the first and second discharge electrode layers 221a and 222a (PW12=PW0) may be closer a shape in which the first and second discharge electrode layers 221a and 222a are formed to extend and thereby decrease in width, rather than a shape in which the first and second protrusions 221a' and 222a' protrude from the first and second discharge electrode layers 221a and 222a, but the shape is not particularly limited thereto.

The width PW12 of the other end of the first region P1 being less than the maximum width (PW0) of each of the first and second discharge electrode layers (PW12 < PW0) may be closer to a shape in which the first and second protrusions 221a' and 222a' protrude from the first and second discharge electrode layers 221a and 222a, but the shape is not particularly limited thereto.

In an example embodiment of the present disclosure, the first and second protrusions 221a' and 222a' may have a shape having a constant width.

In this case, a region having a constant width may be defined as a second region P2.

In other words, the first and second protrusions 221a' and 222a' may include both the first region P1, a region having a decreasing width, and the second region P2, a region having a constant width.

More specifically, the first protrusion 221a' may be formed to extend from the first discharge electrode layer 221a, and may have a shape having a width that is constant and then narrows in a direction toward the second discharge electrode layer 222, and the second protrusion 222a' may be formed to extend from the second discharge electrode layer 222a, and may have a width that is constant and then narrows in a direction toward the first discharge electrode layer 221a.

That is, the second regions P2 of the first and second protrusions 221a' and 222a' may have shapes respectively extending from the first and second discharge electrode layers 221 and 222, and the first regions P1 of the first and second protrusions 221a' and 222a' may have shapes respectively extending from the second regions P2.

More specifically, when a width of the second region P2 is defined as PW2, 0 ≤ PW1 < PW12 ≤ PW2 < PW0 may be satisfied.

That is, the second region P2 may be formed to be narrower than the maximum width of each of the first and second discharge electrode layers 221a and 222a, and may have a protruding shape. A width PW12 of one end of the first region P1 may be equal to or less than the width PW2 of the second region P2, and may have an extending shape.

In this case, a length PL1 of the first region may be the same or different from a length PL2 of the second region. When the length PL1 of the first region is longer than the length PL2 of the second region (PL2<PL1), a sharp shape may be more easily formed. When the length PL2 of the second region is longer than the length PL1 of the first region (PL1<PL2), an electric field may be more stably concentrated without the electric field leaking in other directions. However, the present disclosure is not particularly limited thereto, and a structure capable of more easily concentrating the electric field may be sufficient.

The first and second discharge electrode portions 221a and 222a may be spaced apart from each other. In this case, a region in which the first and second discharge electrode portions 221a and 222a are spaced apart from each other may be defined as the spacer portion 240.

More specifically, the first and second protrusions 221a' and 222a' may include the spacer portion 240 formed therebetween.

The spacer portion 240 may have a shape spaced apart from each other by a predetermined distance from a central portion of the substrate 210, and the predetermined distance may be 1 um or more and 100 um or less.

That is, a size of the spacer portion 240 may be 1 pm or more and 100 um or less. In this case, the size of the spacer portion 240 may refer to a size in the second direction.

The spacer portion 240 may perform a role of ESD by passing. A distance (or 'gap' in Fig. 6A) of the spacer portion 240 between the first and second protrusions 221a' and 222a' may serve to determine an ESD turn-on voltage.

Here, the turn-on voltage may refer to a voltage at which ESD operates and thereby high-voltage static electricity passes through a lead electrode.

When the distance of the spacer portion 240 is less than 1 um, the concentrated electric field E may not be easily discharged through the ESD discharge portion 230. When the distance of the spacer portion 240 is greater than 100 µm, the electric field E may not be easily concentrated, or ESD discharge portion 230 may have an excessively large size, such that a size of the electronic component 10 may increase. However, the distance of the spacer portion 240 is not limited thereto, and the distance may vary depending on the size of the electronic component 10 or the distance may be sufficient as long as it allows ESD discharge to be effectively implemented.

The ESD discharge member 200 may further include an ESD discharge portion 230 disposed to simultaneously cover the end of the first protrusion 221a', the end of the second protrusion 222a', and the spacer portion 240.

More specifically, the ESD discharge portion 230 may be further included to simultaneously cover one end of the first protrusion 221a' , one end of the second protrusion 222a' , and the spacer portion 240.

The ESD discharge portion 230 is disposed on the second surface 210-2 of the substrate and is formed to simultaneously cover one end of the first and second discharge electrode layers 221a and 222a and the spacer portion 240.

The ESD discharge portion 230 may be formed by printing ESD paste on the substrate 210. Here, the ESD paste may be formed by mixing a conductive material and an insulating material.

The conductive material included in the ESD paste may include, for example, at least one of copper (Cu), silver (Ag), palladium (Pd), tin (Sn), nickel (Ni), gold (Au), and alloys thereof, but the present disclosure is not particularly limited thereto.

The insulating material included in the ESD paste may include, for example, a resin such as epoxy or the like, but the present disclosure is not particularly limited thereto.

In an example embodiment of the present disclosure, at least one ESD discharge portion 230 may be provided.

More specifically, the ESD discharge portion 230 may include a first discharge portion 230-1 and a second discharge portion 230-2.

In this case, the first discharge portion 230-1 may simultaneously cover the first-first protrusion 221a'-1, the second-first protrusion 222a'-2, and the first spacer portion 240-1. The second discharge portion 230-2 may simultaneously cover the first-second protrusion 221a'-2, the second-second protrusion 222a'-2, and the second spacer portion 240-2.

As another example, the ESD discharge portion 230 may include a conductive polymer. The conductive polymer may have properties of a nonconductor when a signal voltage input from a signal interface through which a signal is transmitted from a connector to a system or IC, an IC block of a power terminal, or a communication line is on a rated voltage (circuit voltage) level, or may have properties of a conductor when an overvoltage such as ESD occurs instantaneously.

The first and second conductors 221 and 222 may include first and second lower-surface electrode layers 221b and 222b disposed on the first surface 210-1 of the substrate to be spaced apart from each other.

More specifically, the first and second lower-surface electrode layers 221b and 222b disposed on the first surface 210-1 of the substrate may have various shapes, for example, may respectively have rectangular shapes, and the first and second lower-surface electrode layers 221b and 222b may be spaced apart from each other in the second direction without forming a protrusion, but the present disclosure is not particularly limited thereto.

In addition, at least portions of the first and second lower-surface electrode layers 221b and 222b may be disposed to respectively overlap the first and second discharge electrode layers 221a and 222a in the first direction.

In addition, according to an example embodiment of the present disclosure, the first and second conductors 221 and 222 may not be formed on a side surface, perpendicular to the first and second surfaces 210-1 and 210-2 of the substrate.

That is, the first and second conductors 221 and 222 may be respectively formed on the first and second surfaces 210-1 and 210-2 of the substrate, and internal surfaces of the first and second through-holes h1 and h2. However, the first and second conductors 221 and 222 may not be respectively formed on both side surfaces of the substrate 210 in the second direction and both side surfaces of the substrate 210 in the third direction.

The multilayer electronic component 100 may be an open circuit in DC power. However, when a crack occurs in the body 110 due to an external environment, the internal electrodes 121 and 122 may overlap each other or a current path may be generated, resulting in a defect caused by a short circuit. The defect caused by the short circuit may cause overcurrent to flow through undesigned lines, which may adversely affect other components.

In the related art, a margin on a side of an external electrode, which is prone to cracks due to external force, was designed to increase such that a short circuit between both electrodes of an internal electrode does not occur even when a crack occurs. In this case, as the margin increases, an area of the internal electrode implementing capacitance may be relatively reduced.

According to the present example embodiment, the ESD discharge member 200 may be attached to one surface of the multilayer electronic component 100 to provide an ESD bypassing function such as an ESD suppressor, thereby implementing an ESD protection function without changing a design of internal electrodes of a multilayer electronic component.

In addition, overvoltage of the ESD may be controlled by adjusting a distance of the spacer portion 240, a distance between the first and second discharge electrode layers 221a and 222a, or by forming the ESD discharge portion 230.

More specifically, high voltage introduced from the printed circuit board 600 to the multilayer electronic component 100 may flow through the first and second discharge electrode layers 221a and 222a, and then may flow out through the ESD discharge portion 230 formed on the spaced portion 240, thereby preventing the multilayer electronic component 100 from being damaged or defects from being occurring in the multilayer electronic component 100, due to the application of high voltage.

The electronic component 10 according to an example embodiment of the present disclosure may further include first and second conductive bonding layers 310 and 320 disposed between the first and second external electrodes 131 and 132 and the ESD discharge member 200, respectively.

The multilayer electronic component 100 and the ESD discharge member 200 may be bonded through the first and second conductive bonding layers 310 and 320, and more specifically, the first and second external electrodes 131 and 132 and the first and second discharge electrode layers 221a and 222a may be connected by first and second conductive bonding layers 310 and 320, respectively.

That is, the first and second conductive bonding layers 310 and 320 may bond portions of the first and second discharge electrode layers 221a and 222a and portions of the first and second band portions 131b and 132b to each other. In this case, the first and second conductive bonding layers 310 and 320 may fill at least portions of the first and second through-holes h1 and h2, but the present disclosure is not particularly limited thereto, and the first and second conductive bonding layers 310 and 320 may be disposed only in portions in which the first and second through-holes h1 and h2 are not formed.

The first and second conductive bonding layers 310 and 320 are not particularly limited, but may include, for example, a conductive metal or resin. Thus, the first and second external electrodes 131 and 132 and the first and second conductors 221 and 222 may be electrically connected to each other, while bonding strength between the multilayer electronic component 100 and the ESD discharge member 200 may be improved, thereby performing a function of increasing adhesive strength.

Hereinafter, various example embodiments of an electronic component including one ESD discharge member or a plurality of ESD discharge members will be described.

In an example embodiment of the present disclosure, the ESD discharge member may include at least one ESD discharge member. The at least one ESD discharge member may be in contact with the first and second band portions 131b and 132b, and may be disposed on one or more surfaces selected from the first, second, fifth, and sixth surfaces 1, 2, 5, and 6.

More specifically, the ESD discharge member 200 may be coupled to one surface on which the first surface 1 of the body 110 is disposed, that is, a mounting surface of the multilayer electronic component 100, to be in contact therewith.

In the present example embodiment, when the electronic component 10 is mounted on the printed circuit board 600, the ESD discharge member 200 may be disposed between the multilayer electronic component 100 and the printed circuit board 600. In addition, solders 710 and 720, fixing the electronic component 10 to the printed circuit board 600, may be disposed between the first surface 210-1 of the substrate of the ESD discharge member 200 and the printed circuit board 600.

In this case, a portion of the solders 710 and 720 applied to the first surface 210-1 of the substrate may be disposed to fill at least portions of internal spaces of the first and second through-holes h1 and h2 provided in the substrate 210. Thus, when the solders 710 and 720 are disposed to be inserted into the first and second through-holes h1 and h2 and to partially fill the first and second through-holes h1 and h2, a bonding area between the solders 710 and 720 and the ESD discharge member 200 may be increased, thereby increasing adhesive strength between the printed circuit board 600 and the electronic component 10.

According to an example embodiment of the present disclosure, the ESD discharge member 200 may be coupled to the other surface, not the mounting surface of the multilayer electronic component 100, to be in contact therewith. For example, as in the illustrated electronic component 12 (FIG. 11), one ESD discharge member 500 may be disposed on the sixth surface 6 of the body 100 to be in contact with the first and second band portions 131b and 132b. In this case, first and second lower-surface electrode layers of the first and second conductors 521 and 522 disposed on a first surface of a substrate of the ESD discharge member 500 may be coupled toward the outside of the multilayer electronic component 100.

In an example embodiment in which a plurality of ESD discharge members are coupled to the multilayer electronic component 100, the plurality of ESD discharge members may be coupled to the first and second band portions 131b and 132b, respectively, on two or more surfaces among surfaces on which the first, second, fifth, and sixth surfaces 1, 2, 5, and 6 of the body 110 are disposed.

In this case, the number of the plurality of ESD discharge members coupled to one multilayer electronic component 100 is not particularly limited, and a position in which the plurality of ESD discharge members are disposed is also not particularly limited.

For example, as in the illustrated electronic component 11 (FIG. 10), the ESD discharge members 200 and 400 may be disposed on surfaces opposing each other of the multilayer electronic component 100, respectively.

More specifically, one ESD discharge member 200 may be disposed on the first surface 1, the mounting surface of the multilayer electronic component 100, and may correspond to a high-voltage ESD discharge member 200. Another ESD discharge member 400 may be disposed on the second surface 20 of the multilayer electronic component 100, and may correspond to a low-voltage ESD discharge member 400.

That is, a high-voltage ESD discharge member may be disposed on one surface of the multilayer electronic component 100, and a low voltage ESD discharge member may be disposed on the other surface, and thus may be applicable to the electronic component 10 having ESD voltage covering a wider range.

However, the plurality of ESD discharge members may not need to be disposed on surfaces opposing each other of the multilayer electronic component 100, and the plurality of ESD discharge members may be freely disposed on two or more surfaces selected from among the first, second, fifth, and sixth surfaces of the body 110.

Thus, an ESD discharge member may be freely disposed on one surface of the multilayer electronic component 100, thereby increasing space utilization of the electronic component 10 mounted on the printed circuit board 600.

### Board Having Electronic Component Mounted Thereon

FIG. 12 is a schematic perspective view of a board having an electronic component mounted thereon according to an example embodiment in which the electronic component of FIG. 4 is disposed on a printed circuit board.

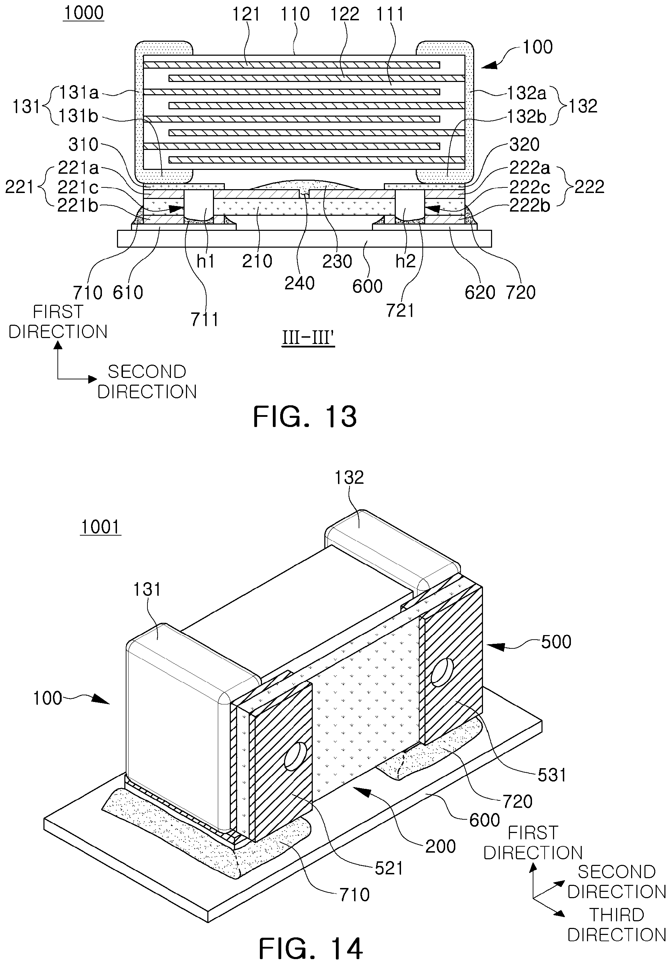

FIG. 13 is a schematic cross-sectional view taken along line III'-III' of FIG. 12.

FIG. 14 is a schematic perspective view of a board having an electronic component mounted thereon, the electronic component obtained by additionally disposing an ESD discharge member on the electronic component of FIG. 12.

Hereinafter, with reference to FIGS. 12 to 14, a board having an electronic component mounted thereon, which is an example embodiment in which an electronic component is mounted on a board, will be described. Details the same as those of the above-described electronic components will be omitted.

According to an example embodiment of the present disclosure, a board 1000 having an electronic component mounted thereon, the board 1000 may include a printed circuit board 600 including at least one pair of electrode pads 610 and 620 thereon, an electronic component 10 disposed on the printed circuit board 600, and solders 710 and 720 connecting the electrode pads 610 and 620 and the electronic component 10 to each other. The electronic component 10 include a multilayer electronic component 100 including a body 110 and first and second external electrodes 131 and 132 disposed outside the body 110, and an ESD discharge member 200 disposed between the multilayer electronic component 100 and the printed circuit board 600. The ESD discharge member 200 may include the ESD discharge member 200 including a substrate 210 having first and second surfaces 210-1 and 210-2 opposing each other and first and second conductors 221 and 222 disposed on the first and second surfaces 210-1 and 210-2 of the substrate 210, and the multilayer electronic component 100 disposed on the second surface 210-2 of the substrate 210. The multilayer electronic component 100 may include a body 110 and first and second external electrodes 131 and 132 disposed outside the body 110 and respectively connected to the first and second conductors 221 and 222. The first and second conductors 221 and 222 may include first and second discharge electrode layers 221a and 222a disposed on the second surface 210-2 of the substrate 210 to be spaced apart from each other and respectively connected to the first and second external electrodes 131 and 132. The first and second discharge electrode layers 221a and 222a may have first and second protrusions 221a' and 222a' respectively extending from both ends thereof spaced apart from each other toward a central portion thereof, and a spacer portion 240 formed between the first and second protrusions 221a' and 222a'. The first and second protrusions 221a' and 222a' may have a first region P1, a region having a width decreasing toward each other.

The pair of electrode pads 610 and 620 may include first and second electrode pads 610 and 620 respectively connected to the first and second conductors 221 and 222 of the ESD discharge member 200 of the electronic component 10.

In this case, in a state in which first and second lower-surface electrode layers 221b and 222b of the first and second conductors 221 and 222 are respectively positioned on the first and second electrode pads 610 and 620 to be in contact therewith, the printed circuit board 600 and the ESD discharge member 200 may be connected to each other by the solders 710 and 720.

The solders 710 and 720 may be disposed to cover various regions. For example, the solders 710 and 720 may be disposed between the first and second electrode pads 610 and 620 and the first and second lower-surface electrode layers 221b and 222b, respectively.

More specifically, the solders 710 and 720 may include a first solder 710 disposed between a first electrode pad 610 and a first lower-surface electrode layer 221b, and a second solder 720 disposed between a second electrode pad 620 and a second lower-surface electrode layer 222b.

In addition, the solders 710 and 720 may be disposed to fill at least portions of the internal space of the first and second through-holes h1 and h2. In this case, volumes and shapes of the solders 711 and 721 disposed in internal spaces of the first and second through-holes h1 and h2 may vary, and the solders 711 and 721 having different volumes and shapes may be formed to be irregular in shape.

Thus, the solders 711 and 721 may be disposed to fill at least portions of the internal spaces of the first and second through-holes h1 and h2, such that a contact area between the multilayer electronic component 100 and the solders 710 and 720, bonding the printed circuit board 600 including the first and second electrode pads 610 and 620 and the ESD discharge member 200 to each other, may be increased, thereby further improving adhesive strength of the electronic component 10.

In addition, the first and second through-holes h1 and h2 provided in the first and second lower-surface electrode layers 221b and 222b may be partially filled with solders 711 and 721 having conductivity, thereby improving electrical connectivity between the first and second conductors 221 and 222.

However, in the present example embodiment, the solders 711 and 721 disposed in the internal spaces of the first and second through-holes h1 and h2 do not necessarily need to be included. In some example embodiments, only one or both of the solders 711 and 721 may be included, or none of the solders 711 and 721 may be included.

In an example embodiment of the present disclosure, the solders 710 and 720 may not be in contact with the multilayer electronic component 100. That is, the solders 710 and 720 may be formed to have a size less than equal to half of a size of each of the first and second through-holes h1 and h2 in the first direction, with respect to cross-sections of the ESD discharge member 200 in the first and second directions. In a region in which the solders 710 and 720 have a size greater than half of the size of each of the first and second through-holes h1 and h2 in the first direction, the solders 710 and 720 may no longer be formed. Accordingly, the solders 710 and 720 may not be in contact with the first and second external electrodes 131 and 132 of the multilayer electronic component 100 positioned above the ESD discharge member 200.

The solders 710 and 720 may have relatively strong attractive force acting on the first and second lower-surface electrode layers 221b and 222b having a material similar to that of the solder 710 and 720. Conversely, the solders 710 and 720 may have relatively weak attractive force acting on the substrate 210 of the ESD discharge member 200 having a material different from that of the solders 710 and 720.

Accordingly, it is possible to suppress the solders 710 and 720 from being formed upwardly in the first direction with respect to cross-sections of the substrate 210 in the first and second directions, and to reduce a degree of vibrations being transferred to the printed circuit board 600 by the solders 710 and 720. In addition, it is also possible to block piezoelectric stress from being directly transferred from the multilayer electronic component 100 to the printed circuit board 600 through the first and second external electrodes 131 and 132, thereby improving the effect of reducing acoustic noise.

However, the shapes of the solders 710 and 720 are not limited thereto. The solders 710 and 720 may be in contact with the multilayer electronic component 100, but may have a small contact area with the multilayer electronic component 100. For example, when a large amount of the solders 710 and 720 are applied to an upper portion of the printed circuit board 600, the solders 710 and 720 may be formed in a region in which the solders 710 and 720 have a size greater than half of the size of each of the first and second through-holes h1 and h2 in the first direction, with respect to the cross-sections of the substrate 210 in the first and second directions.

Even in this case, the solders 710 and 720 may reach the multilayer electronic component 100 through the ESD discharge member 200, such that a contact area between the solders 710 and 720 and the multilayer electronic component 100 may be narrow as compared to an electronic component not including the ESD discharge member 200 according to the related art.

In addition, the electronic component 10 may include the ESD discharge member 200, such that an amount of solder fillet formed around the electronic component may be reduced. Thus, the number of vibrations transferred to the printed circuit board 600 may be reduced, thereby reducing acoustic noise.

In an example embodiment of the present disclosure, a board 1001 having an electronic component mounted thereon may include a plurality of ESD discharge members 200 and 500.

That is, ESD discharge members may be disposed on at least two surfaces of the multilayer electronic component 100, respectively.

For example, when two ESD discharge members are included, as described above, one ESD discharge member 200 may be disposed between the multilayer electronic component 100 and the printed circuit board 600, and another ESD discharge member 500 may be disposed on the sixth surface 6 of the body 110. However, the present disclosure is not particularly limited thereto, and an ESD discharge member may be disposed on at least one of the first, second, fifth, and sixth surfaces of the body 110.

Even in an example embodiment in which a plurality of ESD discharge members are included, the solders 711 and 721 may be disposed to fill at least portions of internal spaces of the first and second through-holes h1 and h2 of the ESD discharge member 200. Volumes and shapes of the solders 710 and 720 disposed in the internal spaces of the first and second through-holes h1 and h2 may vary, and the solders 710 and 720 having different volumes and shapes may be formed to be irregular in shape.

While example embodiments have been shown and described above, it will be apparent to those skilled in the art that modifications and variations could be made without departing from the scope of the present disclosure as defined by the appended claims.

## Claims

1. An electronic component comprising:
an ESD discharge member including a substrate having first and second surfaces opposing each other and first and second conductors disposed on the first and second surfaces of the substrate; and
a multilayer electronic component disposed on the second surface of the substrate,
wherein the multilayer electronic component includes a body and first and second external electrodes disposed outside the body and respectively connected to the first and second conductors,
the first and second conductors include first and second discharge electrode layers disposed on the second surface of the substrate to be spaced apart from each other and respectively connected to the first and second external electrodes,
the first discharge electrode layer has a first protrusion extending in a direction toward the second discharge electrode layer, and the second discharge electrode layer has a second protrusion extending in a direction toward the first discharge electrode layer, and
an end of the first protrusion has a shape having a width narrowing in the direction toward the second discharge electrode layer, and an end of the second protrusion has a shape having a width narrowing in the direction toward the first discharge electrode layer.

2. The electronic component of claim 1, wherein
the width of the first protrusion is measured in a width direction of the first protrusion perpendicular to the direction toward the second discharge electrode layer, and the width of the second protrusion is measured in a width direction of the second protrusion perpendicular to the direction toward the first discharge electrode layer.

3. The electronic component of claim 1, wherein
the ESD discharge member has first and second through-holes passing through the substrate, and
the first and second conductors further include first and second lower-surface electrode layers disposed on the first surface of the substrate to be spaced apart from each other, and first and second via electrodes covering internal surfaces of the first and second through-holes and respectively connecting the first and second lower-surface electrode layers to the first and second discharge electrode layers.

4. The electronic component of claim 1, wherein an end of the first protrusion and an end of the second protrusion have a tapered shape.

5. The electronic component of claim 1, wherein an end of the first protrusion and an end of the second protrusion have a shape having a sharp point.

6. The electronic component of claim 1, wherein
when a maximum width of each of the first and second discharge electrode layers is defined as PW0, and
among two ends of each of the first and second protrusions in a direction in which the first and second protrusions extend towards each other, a width of one end close to a gap between the first and second protrusions is defined as PW12, and a width of the other end is defined as PW1,
0 ≤ PW1 < PW12 ≤ PW0 is satisfied, and
the PW0, PW1, and PW12 are measured in a direction orthogonal to the direction in which the first and second protrusions extend towards each other.

7. The electronic component of claim 6, wherein
when 0 < PW1 is satisfied,
among the two ends of the first and second protrusions, the one end and the other end are parallel to each other.

8. The electronic component of claim 1, wherein a portion of the first protrusion has a shape having a constant width, and a portion of the second protrusion has a shape having a constant width.

9. The electronic component of claim 8, wherein
the first protrusion is formed to extend from the first discharge electrode layer and to have a shape having a width that is constant and then narrows in the direction toward the second discharge electrode layer, and
the second protrusion is formed to extend from the second discharge electrode layer and to have a shape having a width that is constant and then narrows in the direction toward the first discharge electrode layer.

10. The electronic component of claim 1, wherein
when a region in which the first and second discharge electrode layers are spaced apart from each other is defined as a spacer portion,
the spacer portion has a size of 1 um or more and 100 um or less.

11. The electronic component of claim 10, wherein the ESD discharge member further includes an ESD discharge portion disposed to simultaneously cover the end of the first protrusion, the end of the second protrusion, and the spacer portion.

12. The electronic component of claim 1, further comprising:
first and second conductive bonding layers respectively disposed between the first and second external electrodes and the first and second conductors.

13. The electronic component of claim 1, wherein
the body has first and second surfaces opposing each other in a first direction, third and fourth surfaces connected to the first and second surfaces and opposing each other in a second direction, and fifth and sixth surfaces connected to the first to fourth surfaces and opposing each other in a third direction,
the first and second external electrodes include first and second connection portions respectively disposed on the third and fourth surfaces, and first and second band portions extending from the first and second connection portions to portions of the first, second, fifth, and sixth surfaces of the body, and
the first and second conductors are connected to the first and second band portions, respectively.

14. The electronic component of claim 13, wherein
the ESD discharge member includes one or more ESD discharge members, and
the one or more ESD discharge members are in contact with the first and second band portions, and are disposed on one or more surfaces selected from among the first, second, fifth and sixth surfaces of the body.

15. The electronic component of claim 3, wherein
the first protrusion includes one or more first protrusions and the second protrusion includes one or more second protrusions, and
the first through-hole includes one or more first through-holes and the second through-hole includes one or more second through-holes.
